# EUROPEAN PATENT APPLICATION

(11) **EP 1 482 569 A1**
(43) Date of publication of application: **01.12.2004**
(21) Application number: 03012436.6
(22) Date of filing: 30.05.2003
(51) Int. Cl.: H01L 41/053, F02M 51/06

(54) **Piezoelectric assembly**

(71) Applicant: Siemens VDO Automotive S.p.A., 56040 Fauglia (Pisa) (IT)
(72) Inventor: D'Arrigo, Angelo, 57013 Rosignano Solvay (LI) (IT)
(74) Representative: Berg, Peter, Dipl.-Ing.

(57) **Abstract**

Piezoelectric assembly, comprising a piezoelectric element (111) coupled to at least two electrodes and being capable of a mechanical expansion in one dimension, which is inducible by applying an electrical voltage to the at least two electrodes, which piezoelectric element (111) is situated between a first limiting element (12) and a piston element (15), which piston element (15) is movable relative to the first limiting element (12) by the expansion of the piezoelectric element (111); and further comprising an elastic biasing means (16) for applying a bias force onto the piezoelectric element (111) with respect to the first limiting element (12). The invention is characterized by a second limiting element (13) being situated in a fixed distance relative to the first limiting element (12), both limiting elements (12; 13) being firmly attached to a rigid spacer means (112) and the biasing means (16) being situated between the piston element (15) and the second limiting element (13).

## Description

The present invention refers to a piezoelectric assembly, comprising a piezoelectric element coupled to at least two electrodes and being capable of a mechanical expansion in one dimension, which is inducible by applying an electrical voltage to the at least two electrodes, which piezoelectric element is situated between a first limiting element and a piston element, which piston element is movable relative to the first limiting element by the expansion of the piezoelectric element; and further comprising an elastic biasing means for applying a bias force to the piezoelectric element with respect to the limiting element.

Injector assemblies for the injection of fuel into the engines of modern motor vehicles often comprise piezoelectric assemblies as electrically controllable actuators. By means of such an actuator a valve assembly can be operated fast and with high precision.

Piezoelectric elements commonly used in piezoelectric assemblies are known to expand in at least one direction when an electrical voltage is applied to the elements. The direction and the extent of such a expansion is depending on the crystal structure of the piezoelectric elements, the direction of the voltage applied across the elements and the magnitude of the voltage. In common injector assemblies, where the expansion of the piezoelectric elements is used to move a piston element to operate a valve assemblies, the piezoelectric elements and the electrodes used to apply the voltage are usually configured such, that the expansion is mainly parallel to the longitudinal axis of the assembly, i.e. parallel to the movement of the piston element.

In order to achieve a maximum movement of the piston element while applying a voltage as low as possible, the piezoelectric element is situated between the piston element and a fixed limiting element functioning as an abutment. Thus the mechanical expansion of the piezoelectric element yields a pure movement of the movable piston element only, i.e. relative to the limiting element.

When operating repetitively, which is the normal case, it is advantageous to apply a restoring force to the piezoelectric element, which force is substantially lower than the expanding force induced by the application of the voltage. However, the restoring force should be large enough to support the shrinkage of the piezoelectric element when the voltage is lowered or shut off. This provides for a reproducible return of the piston element into its starting position. The restoring force usually is applied by elastic means, which are dimensioned such, that even in the unexpanded case the force applied to the piezoelectric element does not equal zero. Thus, the term bias force or biasing means is used here.

WO 00/08353 discloses a piezoelectric assembly showing the above mentioned features. The biasing means is configured as an elastic tube surrounding the piezoelectric element. On the one side the elastic tube is firmly attached to an upper cap of the piezoelectric element used as limiting means. On the other side the elastic tube is firmly attached to the piston element, which is in direct contact to the piezoelectric element. Thus, when applying the control voltage to the piezoelectric element, the elastic tube is stretched by the expansion of the latter and the restoring or bias force is increased.

There are several disadvantages associated with an assembly according to the cited prior art. First of all it is technically difficult and, thus, expensive to provide an elastic tube suitable for use in an injector assembly, which involves extreme conditions with respect to temperature, number and frequency of repetitions, long lifetime required etc. Secondly it is difficult to support such known assembly providing for a fixed support of the limiting element and a low-friction movement of the piston element. Thus, usually a special housing is required.

The piezoelectric assembly according to the present invention is characterized by a second limiting element being situated in a fixed distance relative to the first limiting element, both limiting elements being firmly attached to a rigid spacer means and the biasing means being situated between the piston element and the second limiting element. The advantage of this configuration is that the biasing means can be reduced to a relatively small, low-cost, internal device allowing for a less expansive construction working more precisely. By using two limiting elements, that are positioned in a fixed distance to each other, the outer dimensions of the assembly are defined as well as two possible application points for outer supporting means. Also, by positioning the biasing means between the second limiting element and the piston element, the biasing means is almost completely internalised, i.e. well protected against outer influences like, e.g. friction of a surrounding housing.

In a preferred embodiment the spacer means is configured as a rigid tube. The major advantage of such an embodiment is that the spacer means configured as a rigid tube can be used as a housing of the assembly protecting it against influences from outside. Also, a rigid tube limited by two fixed limiting elements, that can e.g. be configured as caps firmly attached to both ends of the tube, provides a large area for the application of outer supporting means. However, the rigid spacer means can alternatively be positioned inside the piezoelectric element, e.g. configured as a rigid pin extanding trough a bore penetrating the piezoelectric element.

In an advantageous embodiment of the present invention the biasing means is configured as a Belleville spring. The major advantage of such an embodiment is the very low-cost and robust nature of the Belleville spring used as the biasing means. Also, the force required can be determined exactly by the proper choice of the Belleville spring. In usual applications the relatively short spring deflection of a Belleville spring is sufficient, since the movement of the piston element usually is not very large. However, a large variety of elastic elements, other than a Belleville spring can be used alternatively.

In an advantageous variation of the present invention the second limiting element is provided having a hole and the piston element partially reaching through said hole. The major advantages of this configuration are its easy set-up and, if the hole in the second limiting element, through which the piston element is reaching partially, is a central hole, its coaxial constellation, making its installation within some larger structure extremely simple.

In a preferred embodiment of the present invention at least one of the limiting elements is configured as a cap welded or clinched to the rigid spacer means. As explained above, it is most advantageous to configure the spacer means as a rigid tube with caps as limiting elements firmly attached to the rigid tube. Welding at least one cap to the tube provides an easy to realize and durable connection. However, a clinched connection provides a similar advantage. Those skilled in the art will realize, that these most advantageous types of connecting the limiting elements to the spacer means are also applicable with other geometric configurations.

It is most advantageous to configure the piezoelectric element being configured as a stack of a plurality of piezoelectric discs. Major advantages of such an embodiment are the adaptability of the stack's length according to the specific application, the economic advantage of a plurality of standard sized piezoelectric disks compared to a custom-made large element, and the much lower control voltage needed when electrodes of alternating polarity are positioned between every two disks, compared to contacting only two faces of a single large piezoelectric element.

Preferably the piezoelectric element has an outer coating made from an electrically insulating material. Thus, no further measures have to be taken in order to provide an electrical insulation of the piezoelectric element.

In the following the present invention will be explained in more detail with respect to the drawings, in which
- Figure 1: illustrates a schematic view of a preferred embodiment of the present invention;
- Figure 2: illustrates a sectional view of the embodiment shown in Fig. 1, along the line II-II thereof.

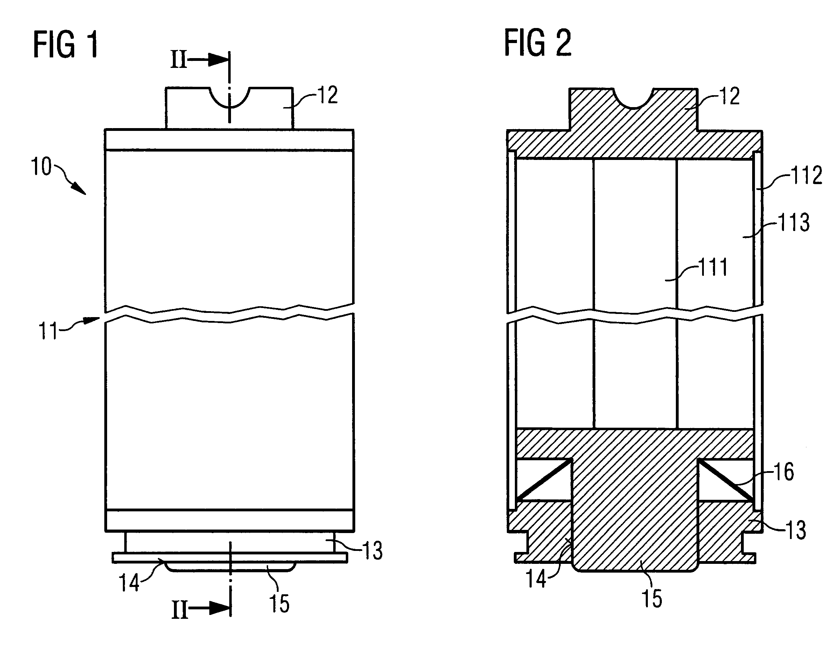

Fig. 1 illustrates a schematic view of a preferred embodiment of the present invention. A piezoelectric assembly 10 comprises a cylindrical body 11, which is described in more detail below with reference to Fig. 2. At one end (the upper one in Fig. 1) of the body 11, there is a cap 12 provided as an upper limiting element. At the other end (the lower one in Fig. 1) there is a corresponding cap 13 provided as a lower limiting element. The lower cap 13 is provided with a central hole 14, through which a movable piston element 15 is partially reaching. In operation, this piston element 15 is used to operate a neighbouring valve assembly (not shown).

Fig. 2 illustrates a sectional view of the embodiment shown in Fig. 1, along the line II-II thereof. The body 11 of the piezoelectric assembly 10 comprises as its heart a piezoelectric element 111, which is capable of expanding along its longitudinal axis, when a suitable voltage is applied to two supply electrodes (not shown). As the upper cap 12 is functioning as an abutment for the piezoelectric element 111, the expansion is translated into a pure movement of the movable piston element 15, which partially reaches through the central hole 14 of the lower cap 13.

A Belleville spring 16 exhibits a biasing as well as a restoring force onto the piston element 15, which force supports the return of the piston element 15 into its starting position as soon as the control voltage is lowered or shut down.

The Belleville spring 16 is positioned in a biased way between the piston element 15 and the lower cap 15.

The upper cap 12 and the lower cap 13 are both firmly attached, in particular welded, to a cylindrical, rigid tube 112, which is functioning as a spacer between the caps 12, 13. Thus the lower cap 13 works as an abutment for the Belleville spring 16.

The piezoelectric element 111 is surrounded by an electrically insulating plastic coating 113, which is sufficently elastic to follow the movements of the piezoelectric element 111 without exhibiting a serious counter-force.

While the invention has been described in the context of a preferred embodiment, it will be apparent to those skilled in the art that the present invention may be modified in numerous ways and may assume many embodiments other than that specifically set out and described above. Accordingly, it is intended by the appended claims to cover all modifications of the invention which fall within the scope of the invention.

## Claims

1. A piezoelectric assembly, comprising a piezoelectric element (111) coupled to at least two electrodes and being capable of a mechanical expansion in one dimension, which is inducible by applying an electrical voltage to the at least two electrodes, which piezoelectric element (111) is situated between a first limiting element (12) and a piston element (15), which piston element (15) is movable relative to the first limiting element (12) by the expansion of the piezoelectric element (111); and
further comprising an elastic biasing means (16) for applying a bias force to the piezoelectric element (111) with respect to the first limiting element (12)
**characterised by**
a second limiting element (13) being situated in a fixed distance relative to the first limiting element (12), both limiting elements (12; 13) being firmly attached to a rigid spacer means (112) and the biasing means (16) being situated between the piston element (15) and the second limiting element (13).

2. The piezoelectric assembly according to claim 1,
**characterised in that**
the spacer means being configured as a rigid tube (112).

3. The piezoelectric assembly according to one of the above claims,
**characterised in that**
the biasing means being configured as a Belleville spring (16).

4. The piezoelectric assembly according to one of the above claims,
**characterised in that**
the second limiting element (13) having a hole (14) and the piston element (15) partially reaching through said hole (14) .

5. The piezoelectric assembly according to one of the above claims
**characterised in that**
at least one of the limiting elements being configured as a cap (12; 13) welded to the rigid spacer means (112).

6. The piezoelectric assembly according to one of the above claims,
**characterised in that**
at least one of the limiting elements being configured as a cap clinched to the rigid spacer means.

7. The piezoelectric assembly according to one of the above claims,
**characterised in that**
the piezoelectric element (111) being configured as a stack of a plurality of piezoelectric discs.

8. the piezoelectric assembly according to one of the above claims,
**characterised in that**
the piezoelectric element (111) having an outer coating (113) of an electrically insulating material.
